# EUROPEAN PATENT APPLICATION

(11) **EP 3 800 477 A1**
(43) Date of publication of application: **07.04.2021**
(21) Application number: 19201474.4
(22) Date of filing: 04.10.2019
(51) Int. Cl.: G01R 31/28

(54) **TESTING DEVICE AND METHOD FOR ELECTRICALLY TESTING AN INTEGRATED CIRCUIT**

(71) Applicant: Afore Oy, 21420 Lieto (FI)
(72) Inventor: HENTTONEN, Vesa, 20380 Turku (FI)
(74) Representative: Berggren Oy, Turku

(57) **Abstract**

The present invention provides a testing device that comprises a chuck (101) for holding at least one integrated circuit (103), a test head (104) for electrically testing the at least one integrated circuit (103), means (110) for changing the relative position between the chuck (101) and the test head (104), means (112, 113) for tilting the chuck (101) and the test head (104) together into different orientations, a reference point (114) arranged on the chuck (101) or the test head (104), and means (115) for detecting the position of the reference point (114). In the testing device according to the invention, the means (110) for changing the relative position between the chuck (101) and the test head (104) is configured, based on the detected positions of the reference point (114), to compensate the relative movement between the chuck (101) and the test head (104) due to tilting. The present invention also relates to a method for electrically testing an integrated circuit (103).

## Description

### TECHNICAL FIELD OF THE INVENTION

The present invention relates to a testing device and a method for electrically testing an integrated circuit according to the preambles of the appended independent claims.

### BACKGROUND OF THE INVENTION

Semiconductor device fabrication is a commonly used process for creating integrated circuits on a wafer made of a semiconductor material using multiple-step sequence of photolithographic and chemical processing steps. As a part of the process, the integrated circuits created on the wafer are typically tested for functional defects by applying special test patterns to them.

Some integrated circuits, such as low-g accelerometers, need to be tested in different orientations in order to determine that they work properly. An example of a testing device for electrically testing integrated circuits in different orientations comprises a chuck for holding a wafer to be tested and a probe card for electrically contacting integrated circuits on the wafer. The probe card is electrically connected to an electronic testing unit that electrically tests the integrated circuits according to a test program. The test program defines the contents of test patterns and the sequence by which they are applied to the integrated circuits. The chuck and the probe card are arranged inside a chamber, which allows the integrated circuits to be tested in a controlled environment. For electrical testing, the probe card is held in place while the wafer mounted on the chuck is moved between testing positions. In each testing position, contact elements of the probe card are arranged in electrical contact with contact pads of a set of integrated circuits, which are then electrically tested with the electronic testing unit. The chuck and the probe card can be tilted together, which allows the integrated circuits to be electrically tested in different orientations.

A problem associated with this testing device relates to the contacting of the integrated circuits with the probe card. When the wafer is tilted into different orientations, there occurs relative movement between the chuck and the probe card, i.e. displacement, due to the gravity. This may lead to failed contacting, especially in a case where the contact pads of the integrated circuits are very small, typically having a side length of less than 50 µm.

### OBJECTIVES OF THE INVENTION

It is the main objective of the present invention to reduce or even eliminate the prior art problems presented above.

It is an objective of the present invention to provide a device and a method for electrically testing an integrated circuit. In more detail, it is an objective of the invention to provide a device and a method enabling to electrically test an integrated circuit in different orientations. It is a further objective of the invention to provide a device and a method enabling to electrically test an integrated circuit with a good contact accuracy and reliability.

In order to realise the above-mentioned objectives, the device and the method according to the invention are characterised by what is presented in the characterising portions of the appended independent claims. Advantageous embodiments of the invention are described in the dependent claims.

### DESCRIPTION OF THE INVENTION

A testing device according to the invention comprises a chuck for holding at least one integrated circuit, a test head for electrically testing the at least one integrated circuit, means for changing the relative position between the chuck and the test head, means for tilting the chuck and the test head together into different orientations, a reference point arranged on the chuck or the test head, and means for detecting the position of the reference point. In the testing device according to the invention the means for changing the relative position between the chuck and the test head is configured, based on the detected positions of the reference point, to compensate the relative movement between the chuck and the test head due to tilting.

The testing device according to the invention can be used for electrically testing one or more integrated circuits, such as low-g accelerometers, in different orientations. The integrated circuits are mounted on the chuck, which can be moved between testing positions using the means for changing the relative position between the chuck and the test head. In each testing position, one or more integrated circuits can be electrically tested with the test head. In order to electrically test the integrated circuits in a different orientation, the chuck and the test head are tilted.

The tilting causes a relative movement, i.e. a displacement, between the chuck and the test head because of the gravity. This relative movement is detected based on a change in the position of the reference point. The means for detecting the position of the reference point can detect the position with respect to the test head when the reference point is arranged on the chuck, or with respect to the chuck when the reference point is arranged on the test head. The relative movement due to tilting is compensated, i.e. corrected, with the means for changing the relative position between the chuck and the test head by utilising the detected positions of the reference point.

The chuck is used to hold one or more integrated circuits. The chuck can be arranged to hold a die comprising a single integrated circuit, or a strip or wafer comprising a plurality of integrated circuits. The chuck can be, for example, a mechanical chuck that comprises a plurality of pins for holding a wafer on a base plate of the chuck. Alternatively, the chuck can be, for example, an electrostatic chuck that comprises a metal base plate coated with a layer of dielectric material. By providing a voltage difference between the metal base plate and a wafer, an electrostatic force holds the wafer on the chuck. To maintain the flatness of the wafer and facilitate the rapid transfer of heat from the wafer, the chuck can be made of a heat conducting material, such as copper or gold. The chuck can be made of gold-plated copper. These materials provide good thermal properties and performance. Preferably, the chuck is a vacuum chuck having grooves on its surface. The grooves are provided with vacuum in order to hold a wafer in place on the chuck and make the wafer flat in a case where it is warped. Alternatively, the chuck can be porous material, which allows to induce vacuum over the whole wafer surface.

The test head is used to electrically test one or more integrated circuits. The test head comprises a probe card and an electronic testing unit. The probe card is used to electrically contact one or more integrated circuits. The probe card may comprise a printed circuit board (PCB) and one or more contact elements, which can be arranged in electrical contact with contact pads of the integrated circuits. The testing device may comprise a digital camera for optically locating the contact elements and the contact pads. By using this information, the contact pads of the integrated circuits to be tested can be aligned with the contact elements of the probe card. The probe card can be, for example, a needle, vertical pin, or MEMS (Micro Electro-Mechanical System) type probe card depending on the shape and form of the contact elements. The contact elements of the probe card can, for example, be made of tungsten or a tungsten/rhenium alloy. The contact pads of the integrated circuits can, for example, be made of aluminium, copper, copper alloys or many types of solders such as lead-tin and tin-silver. Typically, the probe card is custom-built for each type of wafer so that every integrated circuit on the wafer can be electrically tested. The probe card can be attached to a probe card holder.

The electronic testing unit is electrically connected to the probe card. The probe card provides an electrical path between the electronic testing unit and the integrated circuits, thereby permitting the testing and validation of the integrated circuits. The electronic testing unit tests the integrated circuits according to a test program, which defines the contents of test patterns and the sequence by which they are applied to the integrated circuits. The electronic testing unit may comprise a processor and a memory including computer program code, the memory and the computer program code being configured to, with the processor, cause the electronic testing unit to electrically test the integrated circuits.

The means for changing the relative position between the chuck and the test head may comprise means for moving the chuck relative to the test head and/or means for moving the test head relative to the chuck. The means for moving the chuck relative to the test head may comprise one or more actuators for moving the chuck in three perpendicular directions and an actuator for rotating the chuck around an axis perpendicular to the chuck. The means for moving the chuck relative to the test head may comprise a supporting column having a first end and a second end. The first end of the supporting column can be attached to the chuck and the second end of the supporting column to the actuators. The movement produced by the actuators is thus transferred through the supporting column to the chuck. The supporting column can be made of a metal, such as stainless steel, or other material having good mechanical properties. The means for moving the test head relative to the chuck may comprise one or more actuators for moving the test head in three perpendicular directions and an actuator for rotating the test head around an axis perpendicular to the chuck. The actuator may comprise, for example, an electrical motor operating a screw, which transfers the rotational movement to linear movement.

The means for tilting the chuck and the test head together into different orientations may comprise a frame to which the chuck and the test head are attached, and an actuator, such as a servomotor, for tilting (i.e. turning) the frame. The actuator can be arranged to tilt the frame by rotating the frame. The tilting means are preferably capable of tilting the chuck and the test head so that the integrated circuits mounted on the chuck can be arranged in horizontal, vertical and upside-down orientations.

The means for detecting the position of the reference point can be configured to detect the position with respect to the test head when the reference point is on the chuck, or with respect to the chuck when the reference point is on the test head. The reference point can be, for example, a marking on the surface of the chuck or the test head, or an object, such as a glass piece, attached to the chuck or the test head. The object may have a pattern on its surface. The detecting means may comprise an imaging device, such as a digital camera. The imaging device may be attached to the test head when the reference point is arranged on the chuck, or to the chuck when the reference point is arranged on the test head. The imaging device may be attached to the test head or the chuck with an arm that facilitates the placement of the imaging device. The detecting means may comprise a control unit for controlling the imaging device. The control unit may comprise a processor and a memory including computer program code, the memory and the computer program code being configured to, with the processor, cause the control unit together with the imaging device to detect the position of the reference point in different orientations of the chuck and the test head. The detecting means can detect a change in the position of the reference point when the chuck and the test head are tilted from one orientation to another. In other words, the detecting means can detect the relative movement, i.e. a displacement, between the chuck and the test head due to tilting.

The testing device according to the invention can be used in the following manner to electrically test an integrated circuit in two different orientations. First, the integrated circuit mounted on the chuck is electrically tested and the position of the reference point is detected in a first orientation of the integrated circuit. Next, the integrated circuit is tilted to a second orientation and the position of the reference point is detected. After that, the relative movement between the chuck and the test head due to tilting is compensated based on the detected positions of the reference point by changing the relative position between the chuck and the test head. Finally, the integrated circuit is electrically tested in the second orientation of the integrated circuit.

The testing device may comprise a chamber that allows the integrated circuits to be tested in a controlled environment. The chuck and the test head are arranged inside the chamber and attached to the chamber wall with suitable supports. The conditions such as the pressure and temperature inside the chamber can be controlled using various devices. The testing device may comprise, for example, a pump connected to the chamber for controlling the pressure and a temperature control device connected to the chamber for controlling the temperature inside the chamber. The chamber can, for example, be made of stainless steel or aluminium. When testing the integrated circuits, the pressure inside the pressure chamber is typically in the range of 0 to 2 bar, and the temperature inside the pressure chamber is typically in the range of -50 to +150 °C.

The means for tilting the chuck and the test head together into different orientations may comprise an actuator, such as a servomotor, for tilting (i.e. turning) the chamber. The actuator can be arranged to tilt the chamber by rotating the chamber. The tilting means are preferably capable of tilting the chuck and the test head so that the integrated circuits mounted on the chuck can be arranged in horizontal, vertical and upside-down orientations.

An advantage of the testing device according to the invention is that it enables to electrically test an integrated circuit in different orientations. Another advantage of the testing device according to the invention is that it enables to electrically test an integrated circuit with a good contact accuracy and reliability.

According to an embodiment of the invention the reference point is arranged on the chuck and the means for detecting the position of the reference point is attached to the test head. The detecting means is configured to detect the position of the reference point with respect to the test head. The detecting means may comprise an imaging device, such as a digital camera, which is attached to the test head in an immobile manner, i.e. so that it cannot move relative to the test head. The imaging device may be attached to the test head with an arm that facilitates the placement of the imaging device.

According to an embodiment of the invention the reference point is arranged on the test head and the means for detecting the position of the reference point is attached to the chuck. The detecting means is configured to detect the position of the reference point with respect to the chuck. The detecting means may comprise an imaging device, such as a digital camera, which is attached to the chuck in an immobile manner, i.e. so that it cannot move relative to the chuck. The imaging device may be attached to the chuck with an arm that facilitates the placement of the imaging device.

According to an embodiment of the invention the means for tilting the chuck and the test head together comprises a servomotor. The servomotor can be arranged to tilt a frame to which the chuck and the test head are attached. Alternatively, the servomotor can be arranged to tilt a chamber inside which the chuck and the test head are attached. The servomotor is preferably capable of tilting the chuck and the test head so that the integrated circuits mounted on the chuck can be arranged in horizontal, vertical and upside-down orientations. The means for tilting the chuck and the test head together may comprise a control unit for controlling the servomotor. The control unit may comprise a processor and a memory including computer program code, the memory and the computer program code being configured to, with the processor, cause the control unit together with the servomotor to tilt the chuck and the test head into different orientations.

According to an embodiment of the invention the means for detecting the position of the reference point comprises an imaging device. The imaging device, such as a digital camera, is attached to the test head when the reference point is on the chuck, or to the chuck when the reference point is on the test head. The imaging device may be attached to the test head or the chuck with an arm that facilitates the placement of the imaging device. The detecting means may comprise a control unit for controlling the imaging device. The control unit may comprise a processor and a memory including computer program code, the memory and the computer program code being configured to, with the processor, cause the control unit together with the imaging device to detect the position of the reference point in different orientations of the chuck and the test head.

According to an embodiment of the invention the means for changing the relative position between the chuck and the test head comprises at least one actuator attached to the chuck. The at least one actuator enables to move the chuck relative to the test head. The means for changing the relative position between the chuck and the test head may comprise one or more actuators for moving the chuck in three perpendicular directions and an actuator for rotating the chuck around an axis perpendicular to the chuck. The actuator may comprise, for example, an electrical motor operating a screw, which transfers the rotational movement to linear movement.

According to an embodiment of the invention the means for changing the relative position between the chuck and the test head comprises at least one actuator attached to the test head. The at least one actuator enables to move the test head relative to the chuck. The means for changing the relative position between the chuck and the test head may comprise one or more actuators for moving the test head in three perpendicular directions and an actuator for rotating the test head around an axis perpendicular to the chuck. The actuator may comprise, for example, an electrical motor operating a screw, which transfers the rotational movement to linear movement.

According to an embodiment of the invention the reference point is formed with a glass piece having a lattice pattern on its surface. The lattice pattern can be engraved on the surface of the glass piece, for example, by a laser. The glass piece is attached to the chuck or the test head. An advantage of the glass piece is that the lattice pattern on its surface can be easily and accurately detected.

The present invention also relates to a method for electrically testing an integrated circuit. The method according to the invention comprises holding the integrated circuit on a chuck, electrically testing the integrated circuit with a test head, detecting a first position of a reference point that is arranged on the chuck or the test head, tilting the chuck and the test head together into another orientation, detecting a second position of the reference point, changing, based on the detected first and second positions, the relative position between the chuck and the test head to compensate the relative movement between the chuck and the test head due to tilting, and electrically testing the integrated circuit with the test head.

The method according to the invention enables to electrically test an integrated circuit in two different orientations. First, in a first orientation of the integrated circuit, the integrated circuit mounted on the chuck is electrically tested and the first position of the reference point is detected. Next, the integrated circuit is tilted to a second orientation and the second position of the reference point is detected. After that, the relative position between the chuck and the test head is changed, based on the detected first and second positions, to compensate the relative movement between the chuck and the test head due to tilting. Finally, the integrated circuit is electrically tested in the second orientation of the integrated circuit. The first orientation of the integrated circuit can be, for example, a horizontal orientation and the second orientation of the integrated circuit can be, for example, a vertical or an upside-down orientation.

An advantage of the method according to the invention is that it enables to electrically test an integrated circuit in different orientations. Another advantage of the method according to the invention is that it enables to electrically test an integrated circuit with a good contact accuracy and reliability.

According to an embodiment of the invention the integrated circuit is a low-g accelerometer. A low-g accelerometer can typically measure accelerations below 10 g and typically the testing is performed with ±1 g acceleration stimulus, thus using the Earth's gravity.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

The exemplary embodiments presented in this text and their advantages relate by applicable parts to the device as well as the method according to the invention, even though this is not always separately mentioned.

### BRIEF DESCRIPTION OF THE DRAWINGS

- Fig. 1: illustrates a testing device according to an embodiment of the invention in a first testing orientation, and
- fig. 2: illustrates the testing device of fig. 1 in a second testing orientation.

### DETAILED DESCRIPTION OF THE DRAWINGS

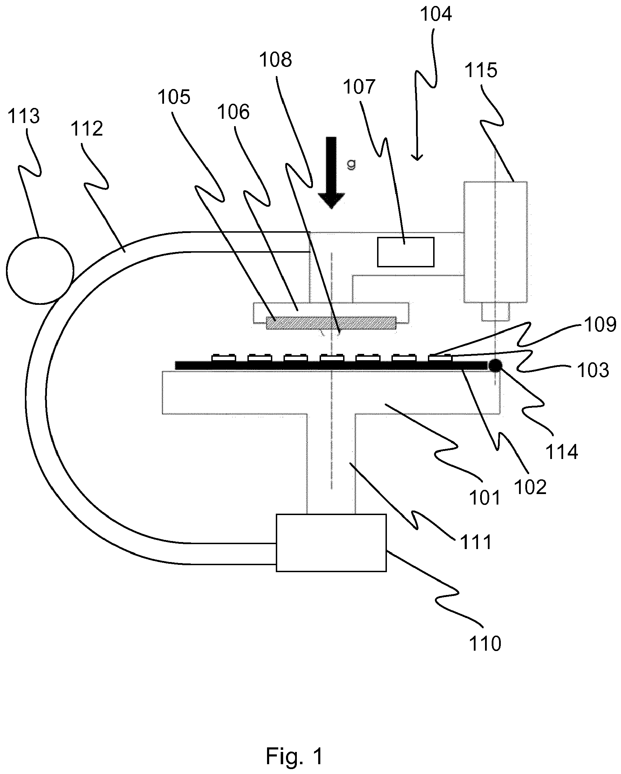

Fig. 1 illustrates a testing device according to an embodiment of the invention in a first testing orientation. The testing device is used for electrically testing integrated circuits in different orientations.

The testing device comprises a chuck 101 holding a wafer 102 that comprises integrated circuits 103. The integrated circuits 103 are electrically tested with a test head 104 that comprises a probe card 105 releasably attached to a probe card holder 106, and an electronic testing unit 107 electrically connected to the probe card 105. The probe card 105 is used to electrically contact the integrated circuits 103. The probe card 105 comprises contact elements 108 that can be arranged in electrical contact with contact pads 109 of the integrated circuits 103. The electronic testing unit 107 tests the integrated circuits 103 according to a test program, which defines the contents of test patterns and the sequence by which they are applied to the integrated circuits 103.

The testing device comprises means for changing the relative position between the chuck 101 and the test head 104. The means for changing the relative position between the chuck 101 and the test head 104 comprises an actuator 110 for moving the chuck 101 relative to the test head 104. The actuator 110 is attached to one end of a supporting column 111. The other end of the supporting column 111 is attached to the chuck 101, whereby the movement produced by the actuator 110 is transferred through the supporting column 111 to the chuck 101. The wafer 102 can be moved between testing positions using the actuator 110. In each testing position, one or more integrated circuits 103 can be electrically tested with the test head 104.

The testing device comprises means for tilting the chuck 101 and the test head 104 together into different orientations. The means for tilting the chuck 101 and the test head 104 together into different orientations comprises a frame 112 to which the chuck 101 and the test head 104 are attached, and an actuator 113 for tilting the frame 112. The chuck 101 is attached to the frame 112 through the supporting column 111 and the actuator 110. By tilting the frame 112, the orientation of the wafer 102 can be changed. This enables the integrated circuits 103 to be electrically tested in different orientations.

When the chuck 101 and the test head 104 are tilted, there occurs a relative movement, i.e. a displacement, between the chuck 101 and the test head 104 due to the gravity, which affects to the structures of the chuck 101 and test head 104 and causes elastic deformations. In order to determine this relative movement, the testing device comprises a reference point 114 arranged on the chuck 101 and means for detecting the position of the reference point 114 with respect to the test head 104. The reference point 114 is a glass piece having a lattice pattern on its surface. The detecting means comprises a digital camera 115, which is attached to the test head 104. With the digital camera 115, the position of the reference point 114 with respect to the test head 104 can be detected in different orientations of the chuck 101 and the test head 104. Thus, a change in the position of the reference point 114 can be determined when the chuck 101 and the test head 104 are tilted from one orientation to another.

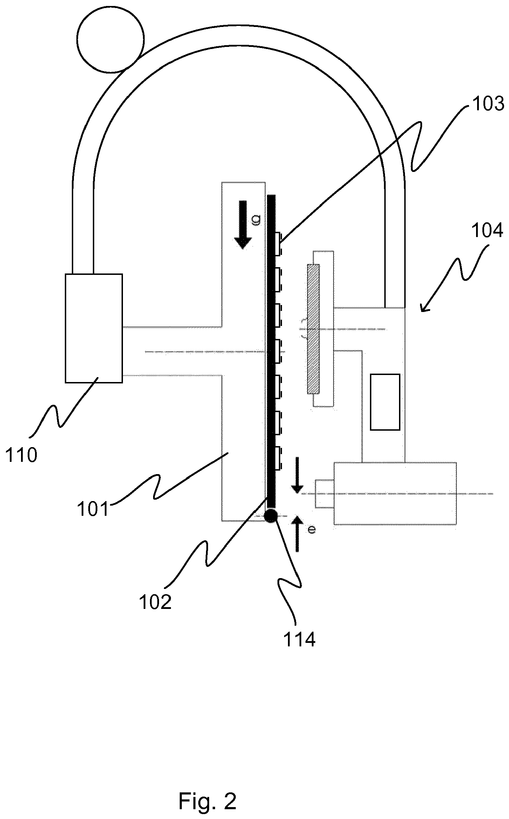

Fig. 2 illustrates the testing device of fig. 1 in a second testing orientation. With reference to fig. 1, the chuck 101 and the test head 104 have been tilted by 90 degrees. As a result of this the wafer 102 has turned from a horizontal position to a vertical position.

As can be seen in fig. 2, the tilting of the chuck 101 and the test head 104 has resulted in a relative movement, i.e. a displacement, between the chuck 101 and the test head 104. This displacement is indicated with two arrows in fig. 2. The relative movement between the chuck 101 and the test head 104 is determined based on the detected positions of the reference point 114 in the first and second testing orientations. Before the integrated circuits 103 are electrically tested on the new orientation of the wafer 102, the actuator 110 is used to compensate, i.e. correct, the relative movement by moving the chuck 101. The relative movement is compensated by moving the chuck 101 into a position where the position of the reference point 114 is the same as the detected position of the reference point 114 in the first testing orientation.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A testing device, comprising:
- a chuck for holding at least one integrated circuit,
- a test head for electrically testing the at least one integrated circuit, and
- means for changing the relative position between the chuck and the test head,
**characterised in that** the testing device comprises:
- means for tilting the chuck and the test head together into different orientations,
- a reference point arranged on the chuck or the test head, and
- means for detecting the position of the reference point,
wherein the means for changing the relative position between the chuck and the test head is configured, based on the detected positions of the reference point, to compensate the relative movement between the chuck and the test head due to tilting.

2. The testing device according to claim 1, **characterised in that** the reference point is arranged on the chuck and the means for detecting the position of the reference point is attached to the test head.

3. The testing device according to claim 1, **characterised in that** the reference point is arranged on the test head and the means for detecting the position of the reference point is attached to the chuck.

4. The testing device according to any of claims 1 to 3, **characterised in that** the means for tilting the chuck and the test head together comprises a servomotor.

5. The testing device according to any of claims 1 to 4, **characterised in that** the means for detecting the position of the reference point comprises an imaging device.

6. The testing device according to any of claims 1 to 5, **characterised in that** the means for changing the relative position between the chuck and the test head comprises at least one actuator attached to the chuck.

7. The testing device according to any of claims 1 to 5, **characterised in that** the means for changing the relative position between the chuck and the test head comprises at least one actuator attached to the test head.

8. The testing device according to any of claims 1 to 7, **characterised in that** the reference point is formed with a glass piece having a lattice pattern on its surface.

9. A method for electrically testing an integrated circuit, comprising:
- holding the integrated circuit on a chuck, and
- electrically testing the integrated circuit with a test head,
**characterised in that** the method comprises:
- detecting a first position of a reference point that is arranged on the chuck or the test head,
- tilting the chuck and the test head together into another orientation,
- detecting a second position of the reference point,
- changing, based on the detected first and second positions, the relative position between the chuck and the test head to compensate the relative movement between the chuck and the test head due to tilting, and
- electrically testing the integrated circuit with the test head.

10. The method according to claim 9, **characterised in that** the integrated circuit is a low-g accelerometer.
